# EUROPEAN PATENT APPLICATION

(11) **EP 4 614 578 A1**
(43) Date of publication of application: **10.09.2025**
(21) Application number: 23897242.6
(22) Date of filing: 27.09.2023
(51) Int. Cl.: H01L 31/10, G01J 1/42, G01J 1/44

(54) **PHOTODETECTION CIRCUIT AND PHOTODETECTION DEVICE**

(30) Priority: 30.11.2022 JP 2022192150
(71) Applicant: Hamamatsu Photonics K.K., Hamamatsu-shi, Shizuoka 435-8558 (JP)
(72) Inventor: SUZUKI, Chihiro, Hamamatsu-shi, Shizuoka 435-8558 (JP); WARASHINA, Yoshihisa, Hamamatsu-shi, Shizuoka 435-8558 (JP); YAMAMOTO, Hiroo, Hamamatsu-shi, Shizuoka 435-8558 (JP)
(74) Representative: Hoffmann Eitle
(86) International application number: PCT/JP2023/035116
(87) International publication number: WO 2024/116583

(57) **Abstract**

A photodetection circuit includes: a photodiode having a light absorption layer that is an InAsSb layer; a first wiring for applying a reverse bias voltage to the photodiode; a TIA having a first input terminal to which a reference voltage is input and a second input terminal connected to the photodiode; an error amplifier having a first input terminal connected to the first input terminal or the second input terminal of the TIA and a second input terminal connected to the output terminal of the TIA, the error amplifier having a period corresponding to the maximum frequency in a frequency band being larger than the pulse width of periodic pulsed light input to the photodiode; and a current sink circuit for drawing a current from the photodiode according to the output voltage from the error amplifier.

## Description

### Technical Field

The present disclosure relates to a photodetection circuit and a photodetection device. This application is based upon and claims the benefit of the priority from Japanese Patent Application No. 2022-192150 filed on November 30, 2022, the entire contents of which are incorporated herein by reference.

### Background Art

Patent Literature 1 discloses a method of suppressing a dark current generated in a photodiode by applying a zero bias between the electrodes of a photodiode containing In and Sb.

### Citation List

### Patent Literature

Patent Literature 1: Japanese Unexamined Patent Publication No. 2008-103742

### Summary of Invention

### Technical Problem

Conventionally, as a readout circuit for converting a current output from a photodiode into a voltage signal, a charge amplifier type readout circuit and a transimpedance amplifier type readout circuit are known. These methods are mainly used for photodiodes having a sensitivity for wavelengths less than 3.0 µm (for example, those having an InGaAs light absorption layer). Since the photodiode having a sensitivity for wavelengths less than 3.0 µm has a parallel resistance of several MΩ or more, the gain of the amplifier can be increased. Even if the photodiode has a parallel resistance of several MΩ or more, when a reverse bias is applied to the photodiode, the effect of the dark current cannot be ignored. Therefore, a circuit configuration that operates with zero bias is desirable.

On the other hand, as photodiodes having a sensitivity for wavelengths of 3.0 µm or more, for example, there is a photodiode having an InAsSb light absorption layer. Since the parallel resistance of such a photodiode having a sensitivity for a relatively long wavelength is approximately several tens of Ω to several kΩ, it is difficult to increase the gain of the amplifier. Therefore, it is desirable to increase the sensitivity itself of the photodiode. For example, the sensitivity can be increased by applying a reverse bias to a photodiode having an InAsSb light absorption layer. However, applying a reverse bias to a photodiode increases the dark current generated in the photodiode. When the dark current increases, the proportion of the steady-state component caused by the dark current in the output voltage from the readout circuit increases. As a result, it becomes difficult to accurately detect the signal component caused by the light input to the photodiode.

It is an object of the present disclosure to provide a photodetection circuit and a photodetection device capable of accurately detecting a signal component caused by light input to a photodiode even if a dark current generated in the photodiode increases.

### Solution to Problem

[1] A photodetection circuit according to the present disclosure includes: a photodiode having a light absorption layer, which is an InAsSb layer, an InAs layer, or an InSb layer, and having a cathode and an anode; a first wiring connected to the cathode of the photodiode to apply a reverse bias voltage to the photodiode; a second wiring having a lower potential than the first wiring; a transimpedance amplifier having a first input terminal to which a reference voltage is input, a second input terminal connected to the anode of the photodiode, and an output terminal; an error amplifier having a first input terminal connected to the first input terminal or the second input terminal of the transimpedance amplifier, a second input terminal connected to the output terminal of the transimpedance amplifier, and an output terminal, the error amplifier having a period corresponding to a maximum frequency in a frequency band being larger than a pulse width of periodic pulsed light input to the light absorption layer of the photodiode; and a current sink circuit connected between the anode of the photodiode and the second wiring to draw a current from the photodiode according to an output voltage from the output terminal of the error amplifier.
[2] Another photodetection circuit according to the present disclosure includes: a photodiode having a light absorption layer, a cathode, and an anode and having a light receiving sensitivity for wavelengths of 3.0 µm or more; a first wiring connected to the cathode of the photodiode to apply a reverse bias voltage to the photodiode; a second wiring having a lower potential than the first wiring; a transimpedance amplifier having a first input terminal to which a reference voltage is input, a second input terminal connected to the anode of the photodiode, and an output terminal; an error amplifier having a first input terminal connected to the first input terminal or the second input terminal of the transimpedance amplifier, a second input terminal connected to the output terminal of the transimpedance amplifier, and an output terminal, the error amplifier having a period corresponding to a maximum frequency in a frequency band being larger than a pulse width of periodic pulsed light input to the light absorption layer of the photodiode; and a current sink circuit connected between the anode of the photodiode and the second wiring to draw a current from the photodiode according to an output voltage from the output terminal of the error amplifier.
   When periodic pulsed light is incident on the photodiode of the photodetection circuit in [1] and [2] above, the periodic pulse signal generated in the photodiode is input to the transimpedance amplifier and converted into a periodic pulse signal component of the output voltage from the transimpedance amplifier. Since the pulse width of this pulse signal component (that is, the pulse width of pulsed light input to the photodiode) is smaller than the period corresponding to the maximum frequency in the frequency band of the error amplifier, the amplification of this pulse signal component by the error amplifier is suppressed. On the other hand, since the photodiode has a light absorption layer that is an InAsSb layer or has a light receiving sensitivity for wavelengths of 3.0 µm or more, a large dark current is generated in the photodiode by the reverse bias voltage applied from the first wiring. This dark current is also input to the transimpedance amplifier and converted into a steady-state component of the output voltage from the transimpedance amplifier. This steady-state component is amplified by the error amplifier and input to the current sink circuit. The current sink circuit draws a current corresponding to the magnitude of the steady-state component, that is, a dark current, from the anode of the photodiode. As a result of such a feedback operation, the dark current flowing from the photodiode to the transimpedance amplifier is reduced. Therefore, according to the photodetection circuits in [1] and [2] above, even if the dark current generated in the photodiode increases, it is possible to accurately detect the pulse signal component caused by the light input to the photodiode.
[3] In the photodetection circuit in [2] above, the photodiode may have a light receiving sensitivity for wavelengths of 5.0 µm or more. In this case, the dark current caused by application of a reverse bias voltage further increases. Therefore, the configuration of the photodetection circuit in [2] above is more effective.
[4] In the photodetection circuit in [2] or [3] above, the light absorption layer may contain In, As, and Sb. In such a case, for example, the photodiode may have a light receiving sensitivity for wavelengths of 3.0 µm or more or 5.0 µm or more.
[5] In the photodetection circuit in any one of [1] to [4] above, the current sink circuit may include a first transistor having a control terminal connected to the output terminal of the error amplifier, a first current terminal connected to the anode of the photodiode, and a second current terminal connected to the second wiring. In this case, the current sink circuit can be configured simply.
[6] In the photodetection circuit in [5] above, the current sink circuit may further include a second transistor connected in series with the first transistor and having a current terminal and a control terminal, the current terminal and the control terminal being diode-connected to each other. Compared with a photodiode having a sensitivity for wavelengths less than 3.0 µm (for example, a photodiode having an InGaAs light absorption layer), in the photodetection circuit in [5] above, the dark current of the photodiode when a reverse bias voltage is applied is significantly large. According to the knowledge of the present inventors, the dark current of the photodiode having an InAsSb light absorption layer is equal to or greater than 1000 times the dark current of a photodiode having an InGaAs light absorption layer. Drawing such a large current with only the single first transistor increases the size of the first transistor. By connecting the second transistor, whose current terminal and control terminal are diode-connected to each other, in series with the first transistor, the overall size of the transistor circuit can be made smaller than when only the single first transistor is provided.
[7] The photodetection circuit in any one of [1] to [6] above may further include a smoothing capacitor connected to a node between the output terminal of the error amplifier and the current sink circuit. In this case, only the dark current can be accurately drawn by further reducing the periodic signal components included in the output voltage from the error amplifier.
[8] The photodetection circuit in any one of [1] to [7] above may further include a switch having one end and another end. The one end of the switch is connected to the node, and the another end of the switch is connected to the output terminal of the error amplifier. The switch switches a connection state between the node and the output terminal of the error amplifier. Alternatively, [9] one end of the switch is connected to the current sink circuit, and the another end of the switch is connected to the output terminal of the error amplifier. The switch switches a connection state between the current sink circuit and the output terminal of the error amplifier. When the switch is in a connected state, the photodetection circuit can achieve the effects described above. In addition, even after the switch is switched from the connected state to the disconnected state, the smoothing capacitor maintains the voltage input to the current sink circuit or the gate voltage is maintained by the gate capacitance of the transistor forming the current sink circuit, so that the current sink circuit continues to draw the dark current, which is a steady-state component, from the photodiode. In addition, since the switch isolates the error amplifier from the current sink circuit, even if a signal component having a pulse width larger than a period corresponding to the maximum frequency in the frequency band of the error amplifier is output from the photodiode, the signal current is amplified by the transimpedance amplifier without the signal current being drawn from the photodiode by the current sink circuit. In this manner, according to the photodetection circuit in [8] or [9] above, by switching the switch as necessary, it is possible to amplify signal components having large pulse widths in addition to signal components having small pulse widths.
[10] In the photodetection circuit in any one of [1] to [9] above, the second wiring may be a reference potential line of the photodetection circuit.
[11] A photodetection device according to the present disclosure includes a light source that outputs the periodic pulsed light and the photodetection circuit in any one of [1] to [10] above. The periodic pulsed light from the light source is input to the light absorption layer of the photodiode. A period corresponding to a maximum frequency in a frequency band of the error amplifier is larger than a pulse width of the periodic pulsed light. According to this photodetection device, since the photodetection circuit in any one of [1] to [10] above is included, a signal component caused by the light input to the photodiode can be accurately detected even if the dark current generated in the photodiode increases.

### Advantageous Effects of Invention

According to the present disclosure, it is possible to provide a photodetection circuit and a photodetection device capable of accurately detecting a signal component caused by light input to a photodiode even if a dark current generated in the photodiode increases.

### Brief Description of Drawings

[FIG. 1] FIG. 1 is a drawing schematically showing the configuration of a photodetection device according to an embodiment of the present disclosure.
[FIG. 2] FIG. 2 is a circuit diagram showing the configuration of a photodetection circuit.
[FIG. 3] FIG. 3 is a drawing showing an example of a stacked structure of a photodiode.
[FIG. 4] FIG. 4 is a drawing showing a relationship between the magnitude of a reverse bias voltage and the characteristics of a photodiode. Part (a) in FIG. 4 is a graph showing a relationship between the magnitude of a reverse bias voltage and the parallel resistance of a photodiode having the structure shown in FIG. 3. Part (b) in FIG. 4 is a graph showing a relationship between the magnitude of a reverse bias voltage and the light receiving sensitivity of a photodiode having the structure shown in FIG. 3.
[FIG. 5] FIG. 5 is a circuit diagram of a photodetection circuit including a specific configuration example of a current sink circuit.
[FIG. 6] FIG. 6 is a circuit diagram showing a charge amplifier type photodetection circuit.
[FIG. 7] FIG. 7 is a circuit diagram showing a TIA type photodetection circuit.
[FIG. 8] FIG. 8 is a graph showing a simulation result of an output voltage waveform from an amplifier when a reverse bias voltage is applied to a photodiode in a TIA type photodetection circuit.
[FIG. 9] FIG. 9 is a graph showing the measurement results of an output voltage from a TIA after designing and prototyping a photodetection circuit according to an embodiment.
[FIG. 10] FIG. 10 is a circuit diagram showing the configuration of a photodetection circuit according to a modification example.

### Description of Embodiments

Hereinafter, embodiments of a photodetection circuit and a photodetection device according to the present disclosure will be described in detail with reference to the accompanying drawings. In addition, in the description of the drawings, the same elements are denoted by the same reference numerals, and repeated description thereof will be omitted.

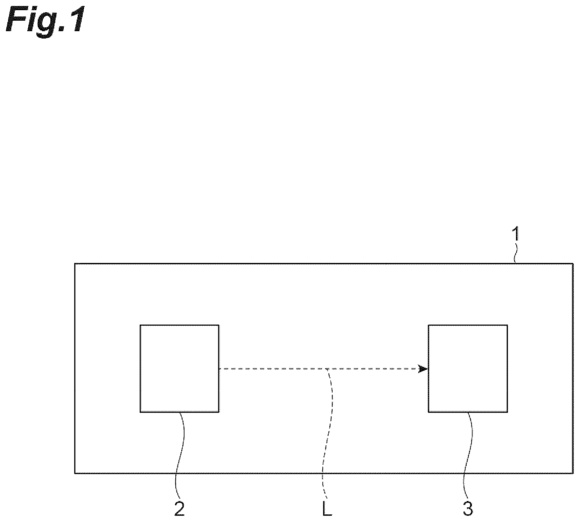

FIG. 1 is a drawing schematically showing the configuration of a photodetection device 1 according to an embodiment of the present disclosure. As shown in FIG. 1, the photodetection device 1 according to the present embodiment includes a light source 2 that outputs periodic pulsed light L, and a photodetection circuit 3 that detects the pulsed light L. The pulsed light L output from the light source 2 is mid-infrared light. The wavelength of the pulsed light L is, for example, 3.0 µm or more, 5.0 µm or more, or 7.0 µm or more. The wavelength of the pulsed light L is, for example, 10 µm or less. The pulse width (full width at half maximum) of the pulsed light L is, for example, 50 nanoseconds or more and 1 microsecond or less, and is 100 nanoseconds in one example. The repetition frequency of the pulsed light L is, for example, 10 kHz or more and 1 MHz or less. As an example, the repetition frequency of the pulsed light L is 500 kHz. The light source 2 may include a semiconductor laser element that outputs the pulsed light L.

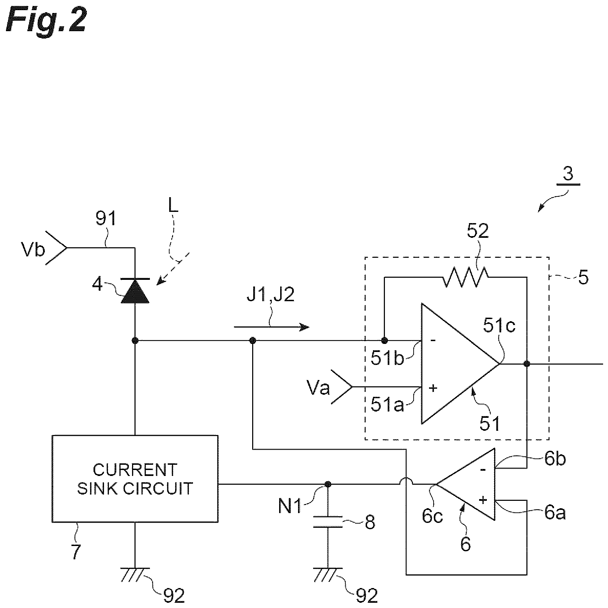

FIG. 2 is a circuit diagram showing the configuration of the photodetection circuit 3. As shown in FIG. 2, the photodetection circuit 3 includes a photodiode 4, a transimpedance amplifier (TIA) 5, an error amplifier 6, a current sink circuit 7, a smoothing capacitor 8, a first wiring 91, and a second wiring 92.

The photodiode 4 receives the pulsed light L from the light source 2. The photodiode 4 has a light receiving sensitivity for the wavelength of the pulsed light L, which is mid-infrared light output from the light source 2. That is, the photodiode 4 has a light receiving sensitivity for wavelengths of, for example, 3.0 µm or more, 5.0 µm or more, or 7.0 µm or more. Alternatively, the photodiode 4 has a light receiving sensitivity for wavelengths of, for example, 10 µm or less. Therefore, the photodiode 4 contains In, As, and Sb in the light absorption layer. The photodiode 4 receives the pulsed light L and outputs a signal current J1 having a magnitude corresponding to the light intensity of the pulsed light L.

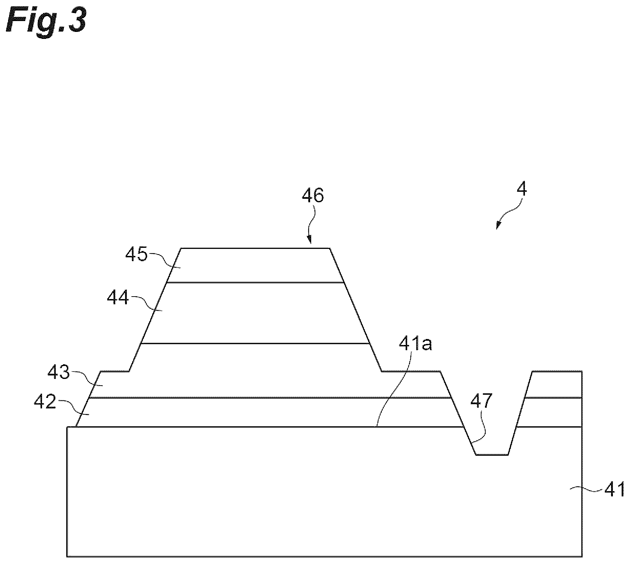

FIG. 3 is a drawing schematically showing an example of the stacked structure of the photodiode 4. In the example shown in FIG. 3, the photodiode 4 includes a semiconductor substrate 41, a buffer layer 42, an n-type semiconductor layer 43, a light absorption layer 44, and a p-type semiconductor layer 45. The semiconductor substrate 41 is, for example, a GaAs substrate. The buffer layer 42 is provided on the main surface 41a of the semiconductor substrate 41. The buffer layer 42 is formed of, for example, n-type InSb. The n-type semiconductor layer 43 is provided on the buffer layer 42. The n-type semiconductor layer 43 is, for example, an n-type InAsSb layer. The light absorption layer 44 is provided on the n-type semiconductor layer 43. The light absorption layer 44 is, for example, an undoped InAsSb layer. The p-type semiconductor layer 45 is provided on the light absorption layer 44. The p-type semiconductor layer 45 is, for example, a p-type InAsSb layer. The band gap of the light absorption layer 44 is smaller than the band gaps of the n-type semiconductor layer 43 and the p-type semiconductor layer 45.

The n-type semiconductor layer 43, the light absorption layer 44, and the p-type semiconductor layer 45 form a mesa structure 46. A trench 47 for insulation is formed around the mesa structure 46 in a plan view. The trench 47 has a depth that reaches from the n-type semiconductor layer 43 to the semiconductor substrate 41. A cathode electrode (not shown) is provided on the exposed surface of the n-type semiconductor layer 43. The cathode electrode is in ohmic contact with the n-type semiconductor layer 43. An anode electrode (not shown) is provided on the exposed surface of the p-type semiconductor layer 45. The anode electrode is in ohmic contact with the p-type semiconductor layer 45.

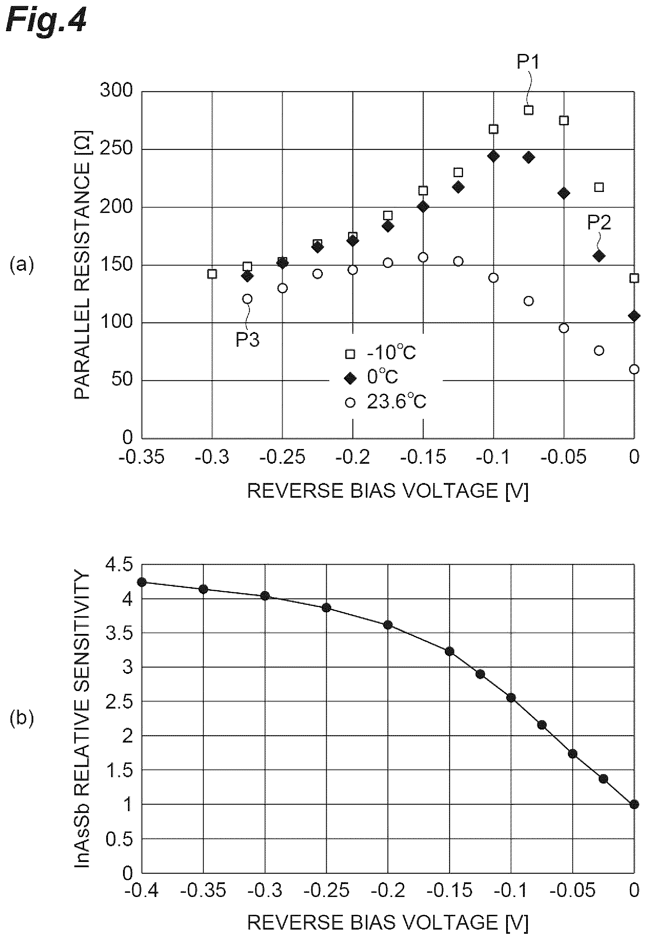

FIG. 2 is referred to again. The cathode of the photodiode 4 is connected to the first wiring 91. The first wiring 91 applies a reverse bias voltage Vb to the photodiode 4. The photodiode 4 further outputs a dark current J2 caused by the reverse bias voltage Vb. FIG. 4 is a drawing showing a relationship between the magnitude of a reverse bias voltage and the characteristics of a photodiode. Part (a) in FIG. 4 is a graph showing a relationship between the magnitude of the reverse bias voltage Vb, and the parallel resistance of the photodiode 4 having the structure shown in FIG. 3. Part (b) in FIG. 4 is a graph showing a relationship between the magnitude of the reverse bias voltage Vb, and the light receiving sensitivity (InAsSb relative sensitivity) of the photodiode 4 having the structure shown in FIG. 3. In part (a) in FIG. 4, a plot P1 shows the parallel resistance at -10°C, a plot P2 shows the parallel resistance at 0°C, and plot P3 shows the parallel resistance at 23.6°C. As shown in FIG. 4, at all temperatures, the parallel resistance increases as the absolute value of the reverse bias voltage Vb increases from 0 V, and the parallel resistance reaches a maximum when a reverse bias voltage having an absolute value of approximately 0.1 V is applied. When the temperature of the photodiode 4 is 23.6°C, the parallel resistance for a reverse bias voltage (absolute value) of 0.1 V is approximately 150 Ω. Therefore, the dark current J2 is J2 = 0.1 V/150 Ω = 0.67 mA.

FIG. 2 is referred to again. The TIA 5 is connected to the anode of the photodiode 4, and converts the current output from the photodiode 4 (a composite current of the signal current J1 and the dark current J2) into a voltage. The TIA 5 includes an amplifier 51 and a feedback resistor 52. The amplifier 51 has a first input terminal 51a, a second input terminal 51b, and an output terminal 51c. In one example, the first input terminal 51a is a non-inverting input terminal, and the second input terminal 51b is an inverting input terminal. A reference voltage Va is input to the first input terminal 51a. The second input terminal 51b is connected to the anode of the photodiode 4. The feedback resistor 52 is connected between the second input terminal 51b and the output terminal 51c. The TIA 5 converts the current input to the second input terminal 51b into a voltage with a gain determined by the feedback resistor 52.

The error amplifier 6 has a first input terminal 6a that is a non-inverting input terminal, a second input terminal 6b that is an inverting input terminal, and an output terminal 6c. The error amplifier 6 amplifies a difference voltage between the voltage input to the first input terminal 6a and the voltage input to the second input terminal 6b, and outputs an amplified difference voltage from the output terminal 6c. The first input terminal 6a is connected to the first input terminal 51a or the second input terminal 51b of the amplifier 51. The second input terminal 6b is connected to the output terminal 51c of the amplifier 51. FIG. 2 shows an example in which the first input terminal 6a is connected to the second input terminal 51b of the amplifier 51. A period corresponding to the maximum frequency in the frequency band of the error amplifier 6 is larger than the pulse width of the pulsed light L input to the photodiode 4. When the pulse width of the pulsed light L is 100 nanoseconds, the frequency band of the error amplifier 6 is, for example, 17 kHz or less.

The current sink circuit 7 is connected between the anode of the photodiode 4 and the second wiring 92. The second wiring 92 is a wiring having a lower potential than the first wiring 91 and is, for example, a reference potential line (GND line) of the photodetection circuit 3. The current sink circuit 7 is further connected to the output terminal 6c of the error amplifier 6, and draws a current from the photodiode 4 according to the output voltage from the output terminal 6c of the error amplifier 6 and causes the current to flow to the second wiring 92. The magnitude of the current drawn by the current sink circuit 7 is, for example, about 1 mA when the light absorption layer 44 of the photodiode 4 is an InAsSb layer and the absolute value of the reverse bias voltage Vb is 0.1 V.

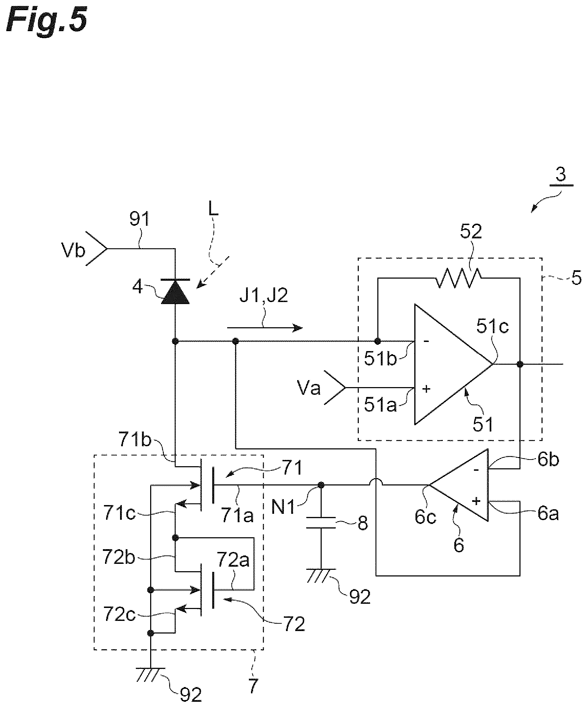

FIG. 5 is a circuit diagram of the photodetection circuit 3 including a specific configuration example of the current sink circuit 7. The current sink circuit 7 shown in FIG. 5 includes a first transistor 71 and a second transistor 72. The first transistor 71 includes a control terminal 71a connected to the output terminal 6c of the error amplifier 6, a first current terminal 71b connected to the anode of the photodiode 4, and a second current terminal 71c connected to the second wiring 92 through the second transistor 72.

The second transistor 72 is connected in series with the first transistor 71 between the first transistor 71 and the second wiring 92. The second transistor 72 includes a control terminal 72a, a first current terminal 72b connected to the second current terminal 71c of the first transistor 71, and a second current terminal 72c connected to the second wiring 92. The control terminal 72a is diode-connected to the first current terminal 72b. The first transistor 71 and the second transistor 72 are, for example, MOSFETs.

The smoothing capacitor 8 is connected between a node N1 between the output terminal 6c of the error amplifier 6 and the current sink circuit 7 and the second wiring 92. That is, one electrode of the smoothing capacitor 8 is connected to the node N1, and the other electrode is connected to the second wiring 92. The smoothing capacitor 8 smoothes the output voltage from the error amplifier 6.

The effects obtained by the photodetection device 1 and the photodetection circuit 3 according to the present embodiment described above will be described together with problems associated with conventional photodetection circuits. As described above, the parallel resistance of the photodiode 4 having a sensitivity for wavelengths of 3.0 µm or more is approximately several tens of Ω to several kΩ, so that it is difficult to increase the gain of the amplifier. Therefore, it is desirable to increase the sensitivity itself of the photodiode 4. For example, the sensitivity can be increased by applying the reverse bias voltage Vb to the photodiode 4.

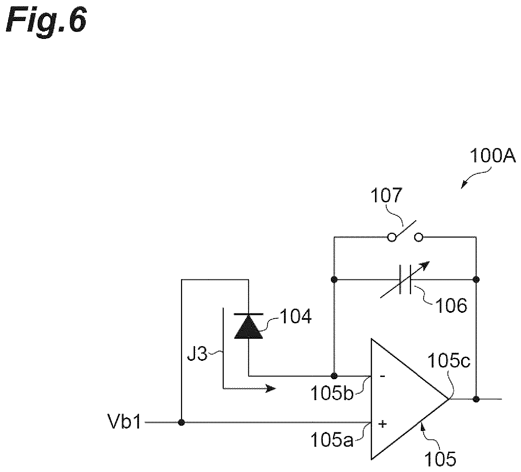

FIG. 6 is a circuit diagram showing a charge amplifier type photodetection circuit 100A. In the photodetection circuit 100A, a bias voltage Vb1 is applied to the cathode of a photodiode 104, and the bias voltage Vb1 is input to a non-inverting input terminal 105a of an amplifier 105. A signal current J3 output from the anode of the photodiode 104 is input to an inverting input terminal 105b of the amplifier 105. A capacitor 106 is connected between the inverting input terminal 105b and an output terminal 105c of the amplifier 105. In addition, a switch 107 for resetting the charge stored in the capacitor 106 is connected in parallel to the capacitor 106.

In this manner, in the charge amplifier method, a circuit configuration (auto-zero method) for minimizing the reverse bias voltage applied to the photodiode 104 is adopted. Therefore, applying the reverse bias voltage to the photodiode 104 deviates from the purpose of the charge amplifier method. In addition, since the gain of the amplifier 105 is large in the charge amplifier method, a signal current from a photodiode having a small parallel resistance, for example, a photodiode having a sensitivity for wavelengths longer than the near-infrared region, is unlikely to flow to the amplifier 105. Therefore, if the charge amplifier type photodetection circuit 100A is used for a photodiode having a small parallel resistance, the sensitivity of the photodetection circuit 100A as a whole is reduced.

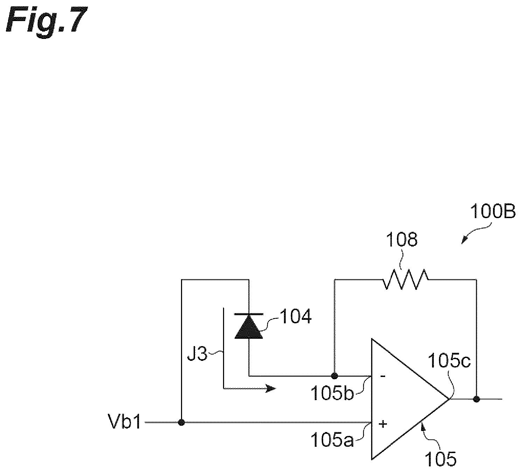

FIG. 7 is a circuit diagram showing a TIA type photodetection circuit 100B. In the photodetection circuit 100B, a feedback resistor 108 is provided instead of the capacitor 106 and the switch 107 in the charge amplifier type photodetection circuit 100A. According to the TIA method, the gain of the amplifier 105 is smaller than that in the charge amplifier method. In addition, the magnitude of the gain of the amplifier 105 can be set according to the magnitude of the parallel resistance of the photodiode 104. In this manner, it is possible to read out the signal current from the photodiode with high sensitivity. However, when the parallel resistance of the photodiode 104 is small, if a reverse bias voltage is applied to the photodiode 104 in the photodetection circuit 100B, a large steady-state component (offset component) is included in the output voltage from the amplifier 105 due to the dark current generated in the photodiode 104. Therefore, when a reverse bias voltage is applied to the photodiode 104, it is difficult to detect only the signal current in the TIA method shown in FIG. 7.

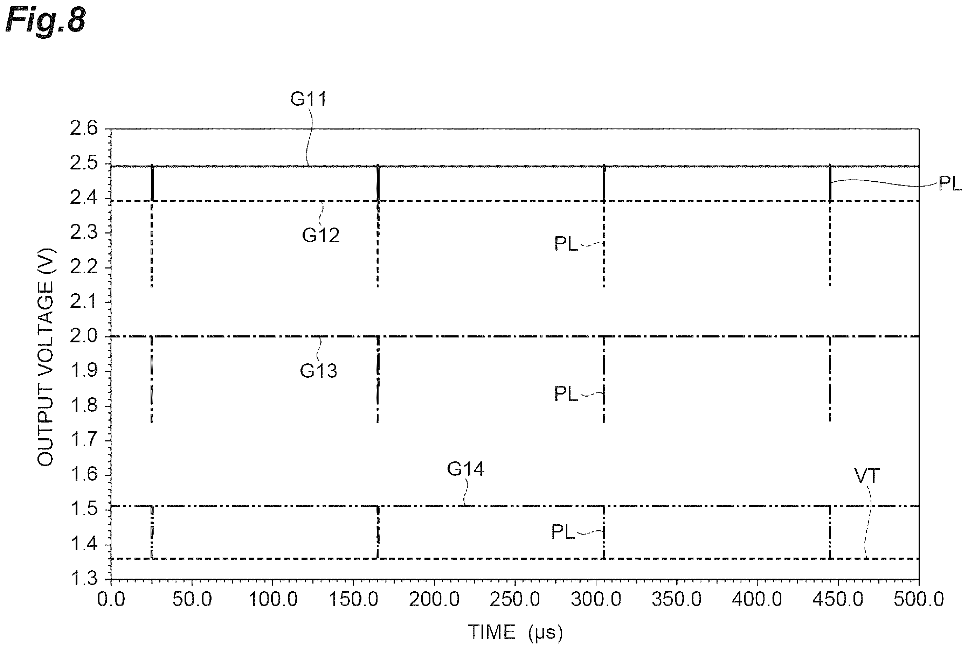

FIG. 8 is a graph showing a simulation result regarding the output voltage waveform from the amplifier 105 when a reverse bias voltage is applied to the photodiode 104 in the TIA type photodetection circuit 100B. Here, it is assumed that the light absorption layer of the photodiode 104 is an InAsSb layer, the parallel resistance of the photodiode 104 is set to 100 Ω and the resistance value of the feedback resistor 108 is set to 1 kΩ. FIG. 8 shows a graph G11 when the absolute value of the reverse bias voltage is 0.00 V, a graph G12 when the absolute value of the reverse bias voltage is 0.01 V, a graph G13 when the absolute value of the reverse bias voltage is 0.05 V, and a graph G14 when the absolute value of the reverse bias voltage is 0.1 V. In these graphs G11 to G14, a pulse waveform PL is a pulse waveform when the incidence of the pulsed light L is assumed. Referring to FIG. 8, it can be seen that as the absolute value of the reverse bias voltage increases, the dark current of the photodiode 104 increases, and the steady-state component of the output voltage from the amplifier 105 moves away from the reference voltage (2.5 V). When the absolute value of the reverse bias is 0.1 V (graph G14), the steady-state component of the output voltage alone is 1.0 V, approaching a saturation voltage VT of the TIA. In this state, the peak of the pulse waveform PL exceeds the saturation voltage VT of the TIA, and an appropriate pulse waveform PL cannot be obtained.

To address the above problem, the photodetection circuit 3 according to the present embodiment operates as follows. When periodic pulsed light L is incident on the photodiode 4, a periodic signal current J1 generated in the photodiode 4 is input to the TIA 5 and converted into a periodic signal component of the output voltage from the TIA 5. The frequency of this signal component, that is, the repetition frequency of the pulsed light L input to the photodiode 4 is larger than the frequency band of the error amplifier 6. Therefore, the amplification of this signal component by the error amplifier 6 is suppressed. On the other hand, the photodiode 4 has the light absorption layer 44 which is an InAsSb layer, or has a light receiving sensitivity for wavelengths of 3 µm or more. Therefore, the large dark current J2 is generated in the photodiode 4 due to the reverse bias voltage Vb applied from the first wiring 91. The dark current J2 is also input to the TIA 5 and converted into a steady-state component of the output voltage from the TIA 5. Since the frequency of this steady-state component is included in the frequency band of the error amplifier 6, the steady-state component is amplified by the error amplifier 6 and input to the current sink circuit 7. The current sink circuit 7 draws a current corresponding to the magnitude of the steady-state component, that is, the dark current J2, from the anode of the photodiode 4. As a result of such feedback operation, the dark current J2 flowing from the photodiode 4 to the TIA 5 is reduced. Therefore, according to the photodetection circuit 3 according to the present embodiment, even if the dark current J2 generated in the photodiode 4 increases, the signal component caused by the pulsed light L input to the photodiode 4 can be accurately detected.

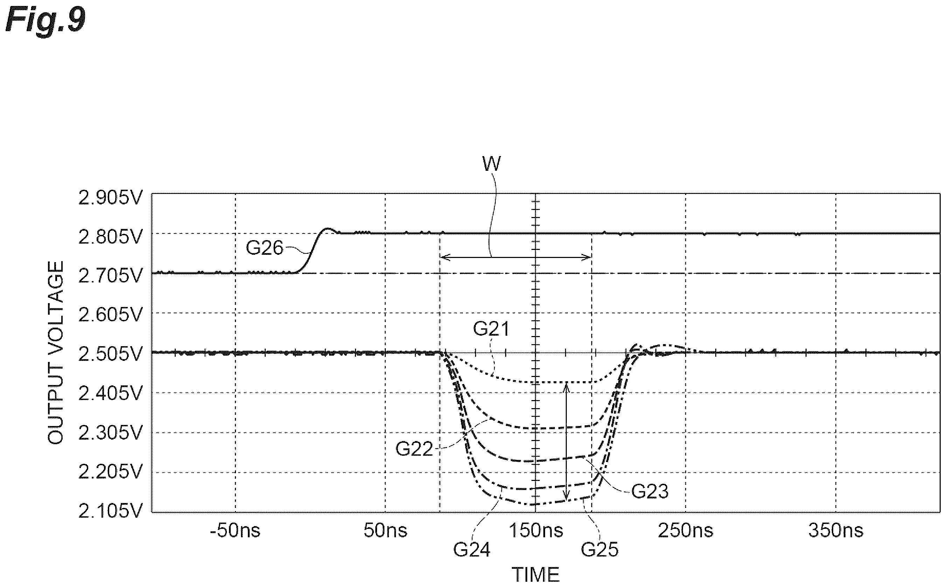

FIG. 9 is a graph showing the measurement results of an output voltage from the TIA 5 after designing and prototyping the photodetection circuit 3 according to the present embodiment. In this prototype, the photodiode 4 had an InAsSb light absorption layer, and the resistance value of the feedback resistor 52 was set to 1 kΩ. FIG. 9 shows a graph G21 when the absolute value of the reverse bias voltage Vb is 0.01 V, a graph G22 when the absolute value of the reverse bias voltage Vb is 0.10 V, a graph G23 when the absolute value of the reverse bias voltage Vb is 0.15 V, a graph G24 when the absolute value of the reverse bias voltage Vb is 0.20 V, and a graph G25 when the absolute value of the reverse bias voltage Vb is 0.25 V. In the drawing, the graph G26 shows a trigger signal waveform, and the double-headed arrow W indicates the irradiation period (pulse width 100 nanoseconds) of the pulsed light L. Referring to FIG. 9, it can be seen that due to the action of the current sink circuit 7, the steady-state component (component when no pulsed light L is incident) of the output voltage is constant at approximately 2.5 V, regardless of the magnitude of the reverse bias voltage Vb. In addition, referring to FIG. 9, it can be seen that the sensitivity of the photodetection circuit 3 improves as the reverse bias voltage Vb increases.

The suitable resistance value of the feedback resistor 52 depends on the magnitude of the parallel resistance of the photodiode 4. The photodiode 4 according to the present embodiment has a light receiving sensitivity for wavelengths of 3 µm or more (or has an InAsSb light absorption layer). Although the parallel resistance value of the photodiode 4 depends on the PN junction area (pixel size), the parallel resistance value of the photodiode 4 having such a light receiving sensitivity is at most about 300 Ω (see FIG. 4). A simulation confirmed that when the feedback resistor 52 was 1 kΩ or less, the entire signal current from the photodiode 4 flew through the feedback resistor 52, but when the feedback resistor 52 was 2 kΩ or more, the signal current flowing through the feedback resistor 52 decreased. Therefore, when the photodiode 4 has a light receiving sensitivity for wavelengths of 3 µm or more (or has an InAsSb light absorption layer), the feedback resistor 52 may be less than 2 kΩ (for example, 1 kΩ).

As described above, the photodiode 4 may have a light receiving sensitivity for wavelengths of 5 µm or more. In this case, the dark current J2 caused by application of the reverse bias voltage Vb further increases. Therefore, the configuration of the photodetection circuit 3 according to the present embodiment is more effective.

As previously described, the light absorption layer 44 may contain In, As, and Sb. In such a case, for example, the photodiode 4 can have a light receiving sensitivity for wavelengths of 3.0 µm or more or 5.0 µm or more.

As in the present embodiment, the current sink circuit 7 may include the first transistor 71 having the control terminal 71a connected to the output terminal 6c of the error amplifier 6, the first current terminal 71b connected to the anode of the photodiode 4, and the second current terminal 71c connected to the second wiring 92. In this case, the current sink circuit 7 can be configured simply.

As in the present embodiment, the current sink circuit 7 may further include the second transistor 72 connected in series with the first transistor 71 and having the first current terminal 72b and the control terminal 72a diode-connected to each other. Compared with a photodiode having a sensitivity for wavelengths less than 3.0 µm (for example, a photodiode having an InGaAs light absorption layer), in the photodiode 4 according to the present embodiment having a sensitivity for wavelengths of 3.0 µm or more (or having an InAsSb light absorption layer), the dark current J2 generated when the reverse bias voltage Vb is applied is significantly large. According to the knowledge of the present inventors, the dark current J2 of the photodiode 4 having an InAsSb light absorption layer is equal to or greater than 1000 times the dark current of a photodiode having an InGaAs light absorption layer. Drawing such a large current with only the single first transistor 71 increases the size of the first transistor 71. By connecting the second transistor 72, whose first current terminal 72b and control terminal 72a are diode-connected to each other, in series with the first transistor 71, the overall size of the transistor circuit can be made smaller than when only the single first transistor 71 is provided.

As in the present embodiment, the photodetection circuit 3 may include the smoothing capacitor 8 connected to the node N1 between the output terminal 6c of the error amplifier 6 and the current sink circuit 7. In this case, only the dark current J2 can be accurately drawn by further reducing the periodic signal components included in the output voltage from the error amplifier 6.

### [Modification examples]

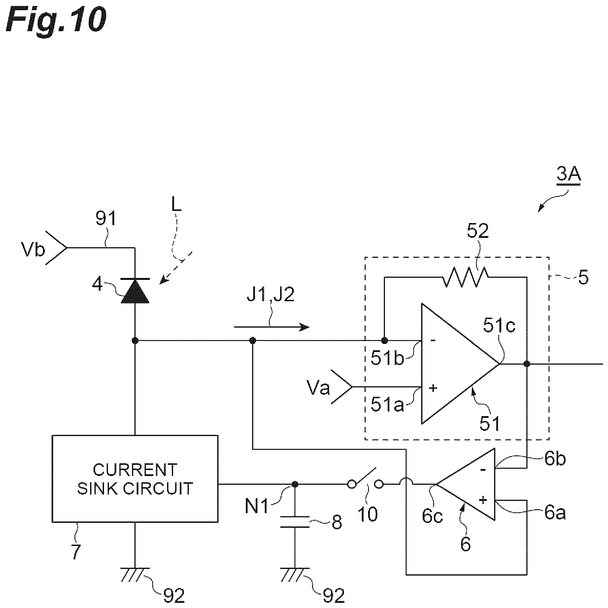

FIG. 10 is a circuit diagram showing the configuration of a photodetection circuit 3A according to a modification example of the embodiment described above. A photodetection circuit 3A according to this modification example further includes a switch 10 in addition to the configuration of the photodetection circuit 3 according to the embodiment described above. One end of the switch 10 is connected to the node N1, and is connected to the current sink circuit 7 through the node N1. The other end of the switch 10 is connected to the output terminal 6c of the error amplifier 6. The switch 10 switches a connection state between the node N1 and the output terminal 6c of the error amplifier 6, in other words, between the current sink circuit 7 and the output terminal 6c of the error amplifier 6. That is, when the switch 10 is in a connected state, the output terminal 6c of the error amplifier 6 and the node N1 are electrically connected to each other. When the switch 10 is in a non-connected state, the output terminal 6c of the error amplifier 6 and the node N1 are electrically isolated from each other. The switch 10 may be a mechanical switch such as an electromagnetic relay, or may be a semiconductor switch such as a transistor.

When the switch 10 is in a connected state, the photodetection circuit 3A performs the same operation as the photodetection circuit 3 according to the embodiment described above, and can achieve the same effects as the photodetection circuit 3 according to the embodiment described above. At this time, since the smoothing capacitor 8 is charged by the output voltage from the error amplifier 6, the voltage across the smoothing capacitor 8 is equal to the output voltage from the error amplifier 6. Thereafter, the switch 10 is switched from the connected state to the non-connected state. Thereafter, the voltage across the smoothing capacitor 8, which is equal to the output voltage from the error amplifier 6 at the time of switching of the switch 10, continues to be input to the current sink circuit 7. Therefore, the current sink circuit 7 continues to draw the dark current J2, which is a steady-state component, from the photodiode 4. The smoothing capacitor 8 is not an essential element, and a similar operation is possible even if another element that stores charges is provided. For example, the gate voltage is also maintained by storing charges by the gate capacitance of the first transistor 71 (see FIG. 5) forming the current sink circuit 7. Therefore, even if the switch 10 is in a disconnected state, the current sink circuit 7 continues to draw the dark current J2, which is a steady-state component, from the photodiode 4. In addition, according to this modification example, the error amplifier 6 is separated from the current sink circuit 7 by the switch 10. Therefore, even if the signal current J1 having a pulse width larger than a period corresponding to the maximum frequency in the frequency band of the error amplifier 6 is output from the photodiode 4 and a voltage obtained by amplifying the voltage caused by the signal current J1 is output from the error amplifier 6, the signal current J1 is amplified by the TIA 5 without being drawn by the current sink circuit 7. In this manner, according to the photodetection circuit 3A according to this modification example, by switching the switch 10 as necessary, it is possible to amplify the signal current J1 having a large pulse width as well as the signal current J1 having a small pulse width.

The photodetection circuit and the photodetection device according to the present disclosure are not limited to the embodiment described above, and various modifications can be made. For example, in the embodiment described above, a photodiode having an InAsSb light absorption layer is exemplified, but the light absorption layer of a photodiode having a light receiving sensitivity for wavelengths of 3.0 µm or more may be an InAs layer or an InSb layer. When the signal component of the pulsed light L is sufficiently reduced in the error amplifier 6, the smoothing capacitor 8 can be omitted.

In the embodiment described above, the current sink circuit 7 including the first transistor 71 and the second transistor 72 is exemplified, but the current sink circuit 7 may include only the single first transistor 71. The current sink circuit 7 is not limited to the configuration shown in FIG. 5 and may have various configurations as long as the current sink circuit 7 has a function of drawing a current from the photodiode according to the output voltage from the error amplifier.

### Reference Signs List

1: photodetection device, 2: light source, 3, 3A: photodetection circuit, 4: photodiode, 5: transimpedance amplifier (TIA), 6: error amplifier, 6a: first input terminal, 6b: second input terminal, 6c: output terminal, 7: current sink circuit, 8: smoothing capacitor, 10: switch, 41: semiconductor substrate, 42: buffer layer, 43: n-type semiconductor layer, 44: light absorption layer, 45: p-type semiconductor layer, 46: mesa structure, 47: trench, 51: amplifier, 51a: first input terminal, 51b: second input terminal, 51c: output terminal, 52: feedback resistor, 71: first transistor, 71a: control terminal, 71b: first current terminal, 71c: second current terminal, 72: second transistor, 72a: control terminal, 72b: first current terminal, 72c: second current terminal, 91: first wiring, 92: second wiring, 100A, 100B: photodetection circuit, 104: photodiode, 105: amplifier, 105a: non-inverting input terminal, 105b: inverting input terminal, 105c: output terminal, 106: capacitor, 107: switch, 108: feedback resistor, J1, J3: signal current, J2: dark current, L: pulsed light, N1: node, PL: pulse waveform, Va: reference voltage, Vb: reverse bias voltage, Vb1: bias voltage, VT: saturation voltage.

## Claims

1. A photodetection circuit, comprising:
a photodiode having a light absorption layer, which is an InAsSb layer, an InAs layer, or an InSb layer, and having a cathode and an anode;
a first wiring connected to the cathode of the photodiode to apply a reverse bias voltage to the photodiode;
a second wiring having a lower potential than the first wiring;
a transimpedance amplifier having a first input terminal to which a reference voltage is input, a second input terminal connected to the anode of the photodiode, and an output terminal;
an error amplifier having a first input terminal connected to the first input terminal or the second input terminal of the transimpedance amplifier, a second input terminal connected to the output terminal of the transimpedance amplifier, and an output terminal, the error amplifier having a period corresponding to a maximum frequency in a frequency band being larger than a pulse width of periodic pulsed light input to the light absorption layer of the photodiode; and
a current sink circuit connected between the anode of the photodiode and the second wiring to draw a current from the photodiode according to an output voltage from the output terminal of the error amplifier.

2. A photodetection circuit, comprising:
a photodiode having a light absorption layer, a cathode, and an anode and having a light receiving sensitivity for wavelengths of 3.0 µm or more;
a first wiring connected to the cathode of the photodiode to apply a reverse bias voltage to the photodiode;
a second wiring having a lower potential than the first wiring;
a transimpedance amplifier having a first input terminal to which a reference voltage is input, a second input terminal connected to the anode of the photodiode, and an output terminal;
an error amplifier having a first input terminal connected to the first input terminal or the second input terminal of the transimpedance amplifier, a second input terminal connected to the output terminal of the transimpedance amplifier, and an output terminal, the error amplifier having a period corresponding to a maximum frequency in a frequency band being larger than a pulse width of periodic pulsed light input to the light absorption layer of the photodiode; and
a current sink circuit connected between the anode of the photodiode and the second wiring to draw a current from the photodiode according to an output voltage from the output terminal of the error amplifier.

3. The photodetection circuit according to claim 2,
wherein the photodiode has a light receiving sensitivity for wavelengths of 5.0 µm or more.

4. The photodetection circuit according to claim 2 or 3,
wherein the light absorption layer contains In, As, and Sb.

5. The photodetection circuit according to any one of claims 1 to 4,
wherein the current sink circuit includes a first transistor having a control terminal connected to the output terminal of the error amplifier, a first current terminal connected to the anode of the photodiode, and a second current terminal connected to the second wiring.

6. The photodetection circuit according to claim 5,
wherein the current sink circuit further includes a second transistor connected in series with the first transistor and having a current terminal and a control terminal, the current terminal and the control terminal being diode-connected to each other.

7. The photodetection circuit according to any one of claims 1 to 6, further comprising:
a smoothing capacitor connected to a node between the output terminal of the error amplifier and the current sink circuit.

8. The photodetection circuit according to claim 7, further comprising:
a switch having one end and another end, the one end being connected to the node and the another end being connected to the output terminal of the error amplifier, the switch switching a connection state between the node and the output terminal of the error amplifier.

9. The photodetection circuit according to any one of claims 1 to 6, further comprising:
a switch having one end and another end, the one end being connected to the current sink circuit and the another end being connected to the output terminal of the error amplifier, the switch switching a connection state between the current sink circuit and the output terminal of the error amplifier.

10. The photodetection circuit according to any one of claims 1 to 9,
wherein the second wiring is a reference potential line of the photodetection circuit.

11. A photodetection device, comprising:
the photodetection circuit according to any one of claims 1 to 10; and
a light source that outputs the periodic pulsed light,
wherein the periodic pulsed light from the light source is input to the light absorption layer of the photodiode, and
a period corresponding to a maximum frequency in a frequency band of the error amplifier is larger than a pulse width of the periodic pulsed light.
